(19) Europäisches Patentamt
European Patent Office
Office européen des brevets

(11) **EP 4 632 986 A1**

(12) **EUROPEAN PATENT APPLICATION**

(43) Date of publication:
**15.10.2025 Bulletin 2025/42**

(21) Application number: **25163745.0**

(22) Date of filing: **14.03.2025**

(51) International Patent Classification (IPC):
*H02J 3/00* (2006.01)     *H02J 3/26* (2006.01)
*H02J 3/32* (2006.01)     *H02J 3/38* (2006.01)
*G01R 29/18* (2006.01)

(52) Cooperative Patent Classification (CPC):
**H02J 3/32; G01R 29/18; H02J 3/001; H02J 3/26; H02J 3/388**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **15.03.2024 US 202463565675 P**

(71) Applicant: **Solaredge Technologies Ltd.
Herzeliya 4673335 (IL)**

(72) Inventor: **COHEN, Chen Baraf
4673335 Herzeliya (IL)**

(74) Representative: **V.O.
P.O. Box 87930
2508 DH Den Haag (NL)**

(54) **APPARATUS, SYSTEM, AND METHOD FOR PROVIDING BACKUP ENERGY**

(57)     Systems and methods are described herein for an electrical system comprising a battery energy storage system, a transformer, an alternating current interface, and an alternating current network coupled to the AC interface. The system may comprise a controller configured to maintain safe provision of power, such as by detecting an islanding condition. For example, the controller may detect changes in current associated with a power phase which are indicative of an islanding condition, disconnect portions of a circuit, detect voltage indicative of the islanding condition, and take responsive action.

Fig. 1

EP 4 632 986 A1

**Description**

**CROSS REFERENCE TO RELATED APPLICATIONS**

This patent application claims priority to, and the benefit of, U.S. Provisional Patent Application No. 63/565,675, filed March 15, 2024, entitled "Apparatus, System, and Method For Providing Backup Energy," which is incorporated herein by reference in its entirety.

**BACKGROUND**

Electrical systems incorporating Battery Energy Storage Systems (BESS) are becoming increasingly popular due to the systems' ability to store and release electrical energy as required. However, when integrating a BESS into a grid-connected electrical system, effective islanding-detection mechanisms may be required, to avoid injecting energy to an electrical device or grid where one or more electrical phases failed, thereby endangering equipment and personnel.

**SUMMARY**

The following summary presents a simplified summary of certain features. The summary is not an extensive overview and is not intended to identify key or critical elements.

Apparatuses, systems, and methods are described for an electrical system comprising a battery energy storage system (BESS), a transformer, an alternating current (AC) interface, and an AC network (e.g. a utility grid, or a distributed energy resource such as a diesel generator) coupled to the AC interface. The system comprises a controller configured to maintain safe provision of power. The controller (which may be implemented using one of more control devices and/or a distributed control architecture) may be employed to receive sensor measurements, perform calculations, detect islanding (or identify a potential islanding condition), or control safety components, such as contactors and switches (such as static switches), to maintain system safety during islanding conditions.

The transformer may be a three-phase (3ph) delta-wye ($\Delta$-Y) transformer comprising three primary windings arranged in a Y-configuration and configured to be connected to an AC electrical network, and three secondary windings arranged in a delta configuration and configured to be connected to a battery inverter (e.g., a bidirectional direct current to alternating current (DC-AC) converter configured to be connected to a battery on a DC side and the transformer on an AC side of the converter). The bidirectional battery inverter is configured to, for example, convert DC power to AC power when discharging the battery and to convert AC power to DC power when charging the battery.

The transformer may be highly advantageous for galvanically isolating the BESS from other system components, such as the AC network, interface and/or AC loads. Arranging the primary windings in a Y-configuration may beneficially enable creation of a neutral point in the center of the Y-configuration, and arranging the secondary windings in a delta ($\Delta$) configuration may beneficially improve balancing of currents output by the battery inverter.

In some systems, a photovoltaic (PV) power source (e.g. one or more PV generators, such as various arrangements of PV cells, substrings of PV cells, PV shingles, PV panels, PV strings comprising strings of PV panels, PV arrays comprising multiple PV strings) may be coupled to one or more DC-AC solar inverters (e.g. microinverters configured to be coupled to PV cells, PV substrings, PV panels, or inverters configured to be coupled to PV strings and/or PV arrays), and the one or more solar inverters may be coupled to the primary side of the transformer.

During a partial islanding condition, for example, if one of three phases of the AC electrical network fails, it may be desirable (and, in some case, necessary) to disconnect the power generation components (e.g., the battery inverter and/or the PV inverter) from the AC network, to avoid injecting power to a failed network component. However, detecting a partial islanding condition may be challenging due to magnetic coupling between the AC network phases and due to natural fluctuations in loading of the system that affect current on the primary windings of the transformer.

Various methods are disclosed herein for effective (e.g., having low false positive rates and low false negative rates) and efficient detection of partial islanding conditions and effective responses. For example, methods disclosed herein include a multi-step detection mechanism configured to reduce false-positive and false-negative detections. Methods disclosed herein include methods for effective backup of loads connected to the system, to ensure continuous power supply to the loads during normal and during suspected or real partial-islanding conditions.

These and other features and advantages are described in greater detail below.

**BRIEF DESCRIPTION OF THE DRAWINGS**

The following summary presents a simplified summary of certain features. The summary is not an extensive overview and is not intended to identify key or critical elements.

Some features are shown by way of example, and not by limitation, in the accompanying drawings. In the drawings, like numerals reference similar elements.

FIG. 1 shows an example energy system.
FIG. 2 shows an example energy system.
FIG. 3 shows an example energy system.
FIGS. 4A and 4B show an example flow diagram.
FIG. 5 shows example waveforms.
FIG. 6 shows example waveforms.

## DETAILED DESCRIPTION

The accompanying drawings, which form a part hereof, show examples of the disclosure. It is to be understood that the examples shown in the drawings and/or discussed herein are non-exclusive and that there are other examples of how the disclosure may be practiced.

In some examples, a controller may be configured to detect an islanding or partial islanding condition in an energy system, using a multi-step method.

In some examples, the energy system may include a battery coupled to a DC/AC converter (which may be described as an inverter), an AC network (e.g., a utility grid and/or AC generators), and a delta-Y ($\Delta$ - Y) transformer connected between the battery inverter and the AC network. The controller may receive measurements from a plurality of current and voltage sensors, analyze the measurements and, based on the measurements, determine whether a potential islanding condition or a confirmed islanding condition has occurred, and trigger responsive action.

In a three-phase electrical system, such as energy system 100A described herein, power may be distributed across three conductors, each carrying an alternating current with a phase difference of 120 degrees between them. This balanced configuration may provide a smooth and efficient power delivery to connected loads, reduce voltage fluctuations, and increase system stability. However, when one phase is lost due to factors such as equipment failure, faults, or disruptions in the power supply, the system may transition from a balanced to an unbalanced state.

The consequences of a loss of phase can be severe, impacting both the electrical infrastructure and the connected equipment. Imbalances in voltage and current distribution can lead to overheating of motors, transformers, loads, and other components, potentially causing damage or operational failures. Moreover, sensitive electronic devices may experience malfunctions or unexpected shutdowns, disrupting critical operations and compromising safety. Loss of a phase may also be referred to as a partial islanding condition.

Loss of a phase may be variously detected. According to some methods, a controller (e.g. a controller 107 as described herein) may rely on monitoring changes in voltage, frequency, or phase angles at a point of common coupling (PCC) between an AC interface (e.g., an AC interface 109) and AC network (e.g., an AC network 110). If these parameters deviate beyond predefined thresholds, indicating grid isolation, the controller may control a switch in order to enter an OFF state and disconnect from a power network. For example, as described below, controller 107 may control STS 108 and contactor 117 to enter the OFF state and disconnect from AC network 110.

In some cases, even when a phase of an AC network such as AC network 110 is lost, magnetic coupling between secondary windings Sa, Sb and Sc and primary windings Pa, Pb and Pc of transformer 105 may cause substantial voltage to be present across all three phases. This may cause voltage measurements provided by a sensor or sensor interface (SSI) to fail to properly indicate that a loss of phase has occurred. For example, consistent with the disclosure herein, there may be a loss of phase at the PCC between AC interface 109 and AC network 110, and voltage measurements provided by SSI 115C might not indicate the loss of a phase. Continued operation of a battery inverter (e.g., batter inverter 104) and other system components under partial islanding conditions may pose a danger to equipment or personnel. Current measurements provided by the SSI may be affected by naturally-occurring variations in power consumption by loads (e.g., loads 106) or changes in power charged or discharged from a battery storage system (e.g., BESS 103), and therefore might not generally be an effective indicator of partial islanding or other potentially problematic events in AC network 110. Thus, it may be advantageous to disconnect certain portions of the circuit following detection of a phase loss condition (e.g., by current changes) in order to then confirm the detection (e.g., by analyzing voltage in a more-isolated circuit).

According to systems and methods disclosed herein, a controller such as controller 107 may be configured to execute a two-step phase loss detection scheme, which may be effective at detecting a phase loss condition (i.e., avoiding false negatives) while reducing a probability of mistakenly determining that a phase has been lost (i.e., a false positive). At a first detection stage, current measurements obtained from an SSI (such as SSI 115C described below) may be compared to and correlated with one another to determine if a phase loss has possibly occurred. If such a risk exists, the controller may take first responsive action. For example, at a second detection stage, voltage measurements obtained from the SSI may be analyzed to determine whether a phase loss has determinatively occurred.

It is noted that the teachings of the presently disclosed subject matter are not bound by the systems and apparatuses described with reference to the figures. Equivalent and/or modified functionality may be consolidated or divided in another manner and may be implemented in any appropriate combination. For example, elements which are shown as separate units, may have their functionalities and/or components combined into a single unit.

It is also noted that like references in the various figures may refer to like elements throughout the application. Similar reference numbers may also connote similarities between elements. Throughout the application certain general references may be used to refer to any of the specific related elements.

It is also noted that all numerical values given in the examples of the description are provided for purposes of example only and do not exclude the use of other numerical values for the same feature.

The terms "substantially" and "about" are used herein to indicate variations that are equivalent for an intended purpose or function (e.g., within a permissible variation range). Certain values or ranges of values are presented herein with numerical values being preceded by the terms "substantially" and "about". The terms "substantially" and "about" are used herein to provide literal support for the exact number that it precedes, as well as a number that is near to or approximately the number that the term precedes. In determining whether a number is near to or approximately a specifically recited number, the near or approximating un-recited number may be a number, which, in the context in which it is presented, provides a substantial equivalent of the specifically recited number.

Control devices, including "controller," "control circuitry," "computer," "processor," "processing circuitry," and variations of these terms as used herein, include any analog or digital electronic hardware circuit capable of performing one or more logical or arithmetic functions. The functions may be based on a received signal (e.g., from a sensor that measures a physical parameter as in the various examples described herein). Performance of the functions may cause an output of a signal (e.g., to control another device such as a switch or to provide an indication as in the various examples described herein). Such control devices include, by way of non-limiting examples, a digital signal processor [DSP], microprocessor, microcontroller, field programmable gate array [FPGA], application-specific integrated circuit [ASIC], embedded controller, analog comparator, analog-to-digital controller, digital-to-analog controller, etc., or combinations thereof. Such control devices may include or be connected to a memory that stores instructions that may be read, interpreted and executed by the devices, and based on the executed instructions, perform any one of functions or control as described herein. The terms "memory" or "data storage device" used herein include any volatile or non-volatile computer memory suitable to the presently disclosed subject matter (e.g., random-access memory [RAM], static random-access memory [SRAM], read-only memory [ROM], erasable programmable read-only memory [EPROM], electrically erasable programmable read-only memory [EEPROM], dynamic random-access memory [DRAM], etc.). The above may include any of the control circuitry disclosed herein. More specifically, by way of non-limiting example, the above may include the control circuitry 210 or 310 disclosed in the present application. Control devices may be included or connected to interface hardware, that converts signals from other devices (e.g., sensors) to signals compatible with the control device (e.g., a comparator or analog to digital [A/D] converter that converts an analog signal to a digital signal), or that converts signals from the control device to signals compatible with another device (e.g., an amplifier for driving a control input of a switch). The control circuitry may be configured to output control signals to control an operational state (e.g., ON, OFF, opened, closed, etc.) of one or more switches.

Sensors/sensor interfaces and variations of these terms as used herein, include any analog or digital electronic hardware circuit capable of performing one or more sensing and/or measurement functions. Current sensors may include sense resistors, Hall effect devices, and other sensor types. Current sensors may be considered substantial "short circuits". For example, "Element A is connected to element B" does not preclude a current sensor being disposed in series between a wire connecting elements A and B. Voltage sensors may include resistive voltage sensors, capacitive voltage sensors, or other types of voltage sensors. Voltage sensors may be considered substantial "open circuits" connected in parallel to other components. For example, "Element A is connected to element B via two wires" does not preclude a voltage sensor being connected between the two wires. Power sensors may include a combination of current and voltage sensors configured to provide measurements from which power can be calculated, or integrated sensors configured to directly provide power measurements.

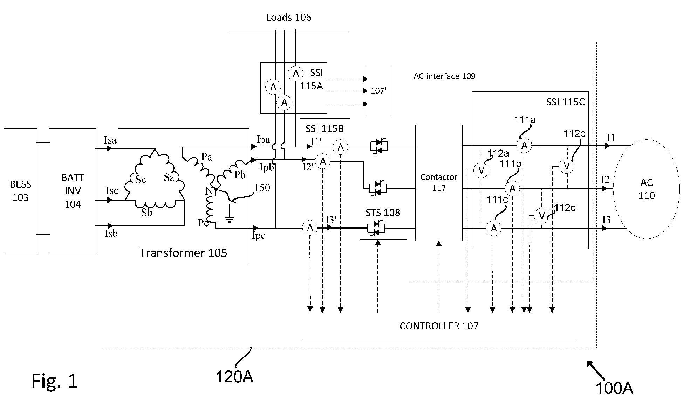

Reference is now made to Fig. 1, which illustrates an energy system 100A. Energy system 100A may include a Battery Energy Storage System (BESS) 103, which may comprise one or more rechargeable batteries (e.g. battery cells, battery packs) that can store, charge and discharge energy. BESS 103 may be viewed as a direct current (DC) power source when providing power (such as during discharging), or as a DC load when consuming power (such as during charging).

Energy system 100A may include a battery inverter (BINV) 104 that may comprise DC terminals coupled to terminals of BESS 103. The BINV may be configured to convert DC power to alternating current (AC) provided at AC terminals when discharging BESS 103, and may be configured to converter AC power from the AC terminals to DC power provided at the DC terminals when charging BESS 103. BINV 104 may be a 3-phase inverter, such as an inverter comprising three AC terminals and configured to provide or receive three phases of AC power, nominally phase-shifted from one another by 120 degrees.

Energy system 100A may include a transformer 105 that may comprise secondary windings Sa, Sb and Sc, coupled to the AC terminals of BINV 104. Secondary-side windings Sa, Sb and Sc may be arranged in a delta configuration, which may provide a benefit of balancing currents Isa, Isb and Isc, provided to or from BINV 104. Transformer 105 may further comprise primary windings Pa, Pb and Pc, magnetically coupled to each other and to secondary windings Sa, Sb and Sc. In cases where transformer 105 provides a voltage conversion ratio, a windings ratio between primary windings Pa, Pb, and Pc may be 1:n, where n may be a rational number greater than zero and represents the voltage conversion ratio. In some cases, n may be equal to one, whereby transformer 105 is configured to provide isolation but maintain a voltage level between the primary and secondary windings. Primary windings Pa, Pb and Pc may be arranged in a wye (Y) configuration, such that neutral point N is formed. Neutral point N may be coupled to switch 150, which may be controlled by a controller (e.g., controller 107, or a separate controller) to be connected to ground when system 100A is operating in an offgrid mode of operation. Switch 150 may be disconnected when system 100A is operating in a grid-tied mode of operation, such as to not interfere with a grounded neutral terminal provided at a different system location (e.g., at AC network 110). Primary windings Pa, Pb and Pc may carry phase currents Ipa, Ipb and Ipc.

Energy system 100A may include a static switch (STS) 108 that may be coupled to primary windings Pa, Pb and Pc and may be operated by a controller (e.g., controller 107) to connect or disconnect primary windings from AC interface 109. STS 108 may be a solid-state device, configured to switch between ON/OFF states at high switching speeds compared to electromechanical switching devices, and may be configured to switch while carrying substantial current.

Energy system 100A may include loads 106 that may be coupled to AC lines between primary windings Pa, Pb and Pc, and STS 108. Loads 106 may comprise one or more single-phase loads or one or more three-phase loads. Loads 106 may comprise smart loads, which may communicate with higher-layer control device and/or be remotely connected or disconnected from the primary windings. Loads 106 may comprise "unintelligent" loads which are permanently coupled to AC lines between primary windings Pa, Pb and Pc, and STS 108.

Energy system 100A may include a sensor or sensor interface (SSI) 115A that may be coupled between primary windings Pa, Pb and Pc, and loads 106, and may comprise current or voltage sensors configured to monitor current, voltage or power provided to loads 106, e.g., for metering, analysis and optimization. In Fig. 1, only current sensors are illustrated explicitly for SSI 115A, but voltage sensors configured to measure line-to-line voltage provided to the loads may also be included. Measurements from SSI 115A may be provided to a controller, e.g. controller 107'. Controller 107' may be part of or communicatively coupled to controller 107, but is drawn separately from controller 107, to reduce visual noise in Fig. 1.

Energy system 100A may include an SSI 115B that may be coupled between primary windings Pa, Pb and Pc, and static switch (STS 108). SSI 115B may comprise current and/or voltage sensors configured to monitor current, voltage or power provided to STS (e.g., for metering, analysis and optimization). In Fig. 1, only current sensors are illustrated explicitly for SSI 115B, but voltage sensors configured to measure line-to-line voltage provided to STS 108 may also be included.

Energy system 100A may include an AC interface 109 that may be coupled between STS 108 and AC network 110. AC interface 109 may comprise SSI 115C, which may comprise current sensors 111a, 111b, and 111c, each coupled to and configure to measure current flowing through a corresponding AC phase. SSI 115C may comprise voltage sensors 112a, 112b and 112c, each coupled between and configured to measure voltage across corresponding AC phases. AC interface 109 may comprise contactor 117, configured to disconnect the sensors from AC network 110. Contactor 117 may comprise electromechanical contacts configured to galvanically isolate AC network 110 from STS 108, loads 106, and transformer 105 when in the OFF position. Contactor 117 may be designed to optimally switch under zero-current conditions, to reduce risk of current arcing, and may be designed to have relatively slow switching speeds compared to solid state devices such as STS 108.

Energy system 100A may include an AC network 110 that may be a 3-phase electrical network such as a 3-phase utility grid, or a 3-phase AC generator such as a diesel generator.

Energy system 100A may include a controller 107 that may be coupled to and receive measurements from sensor-to-sensor interfaces 115A, 115B or 115C. Controller 107 may comprise a processor and memory comprising instructions that, when executed by the processer, monitor the measurements and, based on the measurements, determine whether a partial or full potential islanding or islanding event has occurred. Controller 107 may be configured to control STS 108 and AC interface 109 (e.g., contactor 117). The instructions may cause the controller to, at a first time, determine that a partial islanding condition may have occurred and trigger a first response, and then, at a second time and based on further measurements, confirm that the partial islanding condition has occurred or, conversely, that the partial islanding condition has not occurred and accordingly trigger a second response.

Controller 107 may control STS 108 and contactor 117 to connect or disconnect transformer 105 and loads 106 from AC interface 109. When STS is in the OFF state, such that AC interface 109 is disconnected from transformer 105, magnetic intercoupling of the windings of transformer 105 may have a reduced (or negligible) effect on measurements obtained by SSI 115C. When contactor 117 is also in the OFF state, AC network 110 is galvanically isolated from transformer 105 and loads 106, which may be a requirement in certain networks.

Transformer 105, SSIs 115A-115C, STS 108, contactor 117 and controller 107 may collectively be part of backup interface (BUI) 120A. BUI 120A may comprise a single housing, with ports and terminals configured to connect to loads 106, AC network(s) 110, BINV 104, or additional external devices. Controller 107 may be communicatively coupled to both upstream and downstream control devices, and may comprise communication device(s) (not explicitly illustrated) configured to facilitate transfer of control and data communications between the various controllers. For example, controller 107 may be configured to communicate (e.g., using a wired or wireless communication channel) with a controller of BINV 104 to control charge or discharge policies implemented by the BINV 104. Controller 107 may be configured to communicate with a remote server or network controller configured to provide data or commands required for interfacing with AC network 110.

Controller 107 may receive voltage or current measurements from SSI 115C, and may process the measurements to determine whether an abnormal event in AC network 110 has occurred. An abnormal event may trigger responsive action such as disconnecting loads 106 and/or transformer 105 from AC network 110.

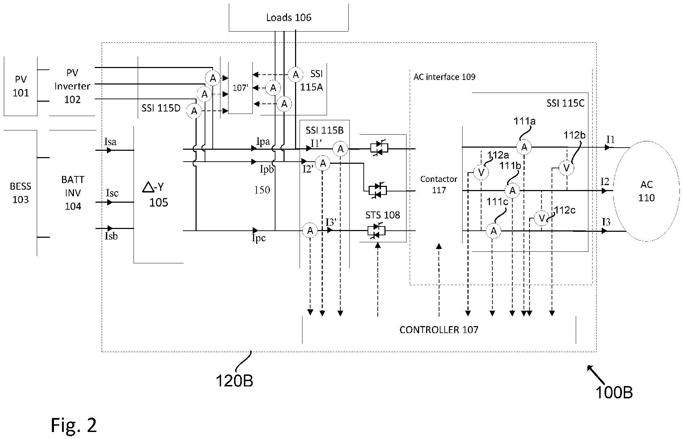

Reference is now made to Fig. 2, which illustrates energy system 100B including backup interface (BUI) 120B according to aspects of the disclosure herein. Energy system 100B may be similar to energy system 100A, with an addition of photovoltaic power source (PVPS) 101 coupled to PV inverter 102 and corresponding additional input terminals to BUI 120B to facilitate connecting to PV inverter 102. PV inverter may be a 3-phase inverter, with three output phases coupled to primary windings Pa, Pb and Pc (not shown explicitly in Fig. 2, as internal details of transformer 105 are not drawn in Fig. 2). PVPS 101 may include DC-DC optimizers (e.g., substring optimizers, module or panel optimizers, or string optimizers) configured to maximum power point track PV generators coupled thereto. In some cases, PV inverter 102 may include a maximum power point tracking circuit in addition to, or instead of, the DC-DC optimizers.

PV inverter 102 may draw DC power from PVPS 101 and convert the DC power to AC power to be provided to loads 106, to AC network 110 (via STS 108 and AC interface 109), or to BINV 104. For example, BINV 104, when operating in charge mode, may convert the AC power provided by PV inverter 102 to DC power used to charge BESS 103. SSI 115D may comprise voltage and/or current sensors configured to measure AC current(s) and/or voltage(s) of the three phases output by PV inverter 102, and may provide the measurements to controller 107', which may be part of or communicatively coupled to controller 107.

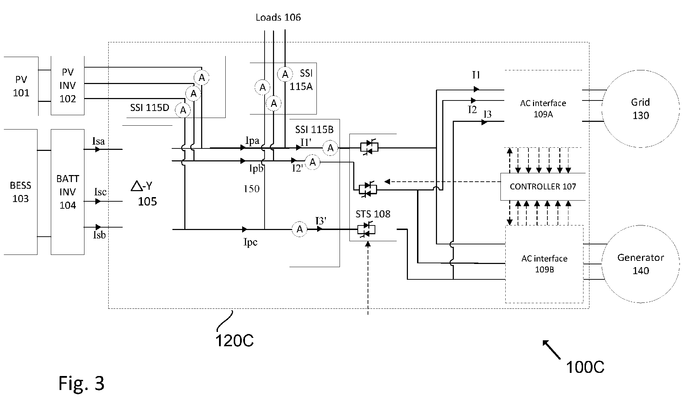

Reference is now made to Fig. 3, which illustrates energy system 100C including backup interface (BUI) 120C according to aspects of the disclosure herein. BUI 120C may be similar to BUIs 120A and 120B, with an additional AC interface. AC interfaces 109A and 109B may comprise components similar to or the same as those of AC interface 109 (e.g. contactors, sensors/sensor interfaces). AC interface 109A may be coupled to grid 130, which may be a 3-phase utility grid. AC interface 109B may be coupled to generator 140 (e.g., a diesel generator) configured to provide AC power to BUI 120C (via AC interface 109B) at certain times (e.g., when grid 130 is down, or when the price of power drawn from grid 130 is high). In some cases, grid 130 and generator 140 might not be synchronized (e.g., both providing AC power at a common voltage amplitude, frequency and phase), in which case only one may be coupled to STS 108 at a time. For example, when power is being drawn from or provided to grid 130, generator 140 may be disconnected via a contactor 117 of AC interface 109B, and when one or more phase of grid 130 are faulty, grid 130 may be disconnected via a contactor 117 of AC interface 109A while generator 140 may be connected and may provide power to loads 106.

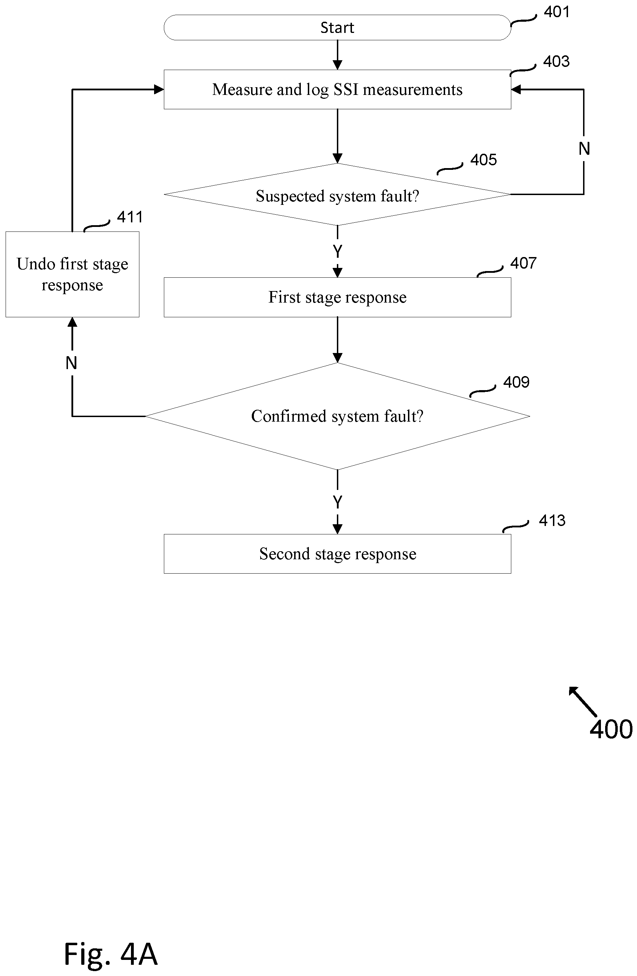

Reference is now made to Fig. 4A, which illustrates a method for detecting potential and confirmed islanding conditions in AC networks. Method 400 may be applied to any of energy systems 100A-100C and carried out by a controller (e.g., controller 107 of BUIs 120A, 120B or 120C). Method 400 may be carried out by a remote controller (e.g., a cloud-based server), with operational commands sent from the remote controller to a local controller.

At step 401, the start of method 400, an energy system such as systems 100A-100C may be operating according to the disclosure herein. For example, considering system 100B, a utility grid may be connected as AC network 110, battery inverter 104 may be discharging BESS 103 at a first rate of discharge, and loads 106 may be drawing power from both AC network 110 and BESS 103 (via BINV 104). At step 403, SSI 115C may be providing voltage and current measurements to controller 107, which may monitor (e.g., identify and track changes in) and log the measurements over time. At step 405, the controller may check for a possible system fault (e.g., a loss of one or more phases of AC network 110). At step 405, such as if the controller determines that a system fault may have occurred, the controller may proceed to step 407 and initiate a first stage response. For example, if the controller determines that an AC network phase has failed (for example, based on one of the current sensors of SSI 115B providing a measurement of zero current and the other current sensors of SSI 115B providing current measurements equal to a total current measured previously) the controller may control STS 108 to rapidly disconnect loads 106 from the AC network. Controller 107 may, such as part of the first stage response, operate contactor 117 to galvanically isolate loads 106 from the AC network, and command BINV 104 to increase power production (or increase a power production limit) drawn from BESS 103 to provide power to loads 106.

Controller 107 may, at step 409, confirm whether the system fault is determined to have occurred. For example, where a phase loss is suspected, controller 107 may obtain voltage measurements from SSI 115B. Since, at step 409, transformer 105 is no longer connected to SSI 115B, SSI 115B is not expected to measure voltage caused by mutual magnetic coupling between the windings of transformer 105. Therefore, if SSI 115B provides voltage measurements indicating normal AC network voltage present at all three phases, controller 107 may determine that no phase loss event occurred. Thus, at step 411, controller 107 may undo the first stage response (e.g., reconnect AC network to transformer 105 and loads 106 by turning on contactor 117, and then STS 108).

If, at step 409, controller 107 confirms that the suspected system fault indeed occurred (for example, by analyzing voltage measurements provided by SSI 115B and determining that one of the three phases has failed) the controller may proceed to step 113 and initiate a second stage response. For example, the second stage response may include sending a message to a system controller to report the system fault. The second stage response may include causing BINV 104 to modify a charge or discharge mode to a power-conservation mode, which may reduce the amount of power discharged. This may enable BESS 103 to maintain sufficient energy for a potentially long AC network outage. The second stage response may include causing some or all of loads 106 to disconnect. This may reduce the power drawn from BESS 103. For example, non-critical loads may be disconnected. If loads 106 include smart loads, controller 107 may cause a signal to be sent to the smart loads. The signal may instruct the smart loads to disconnect themselves.

In some cases, a system fault may be detected definitively in a single step. In these cases, the controller may select a response depending on the nature of the fault. For example, if, at step 405, controller 107 determines that a current I2 measured on an AC phase by SSI 115B is substantially different from a current I2' measured on the same AC phase by SSI 115A, controller 107 may determine that STS 108 or contactor 117 is damaged, and may disconnect STS 108 and contactor 117, and report the fault to a system controller.

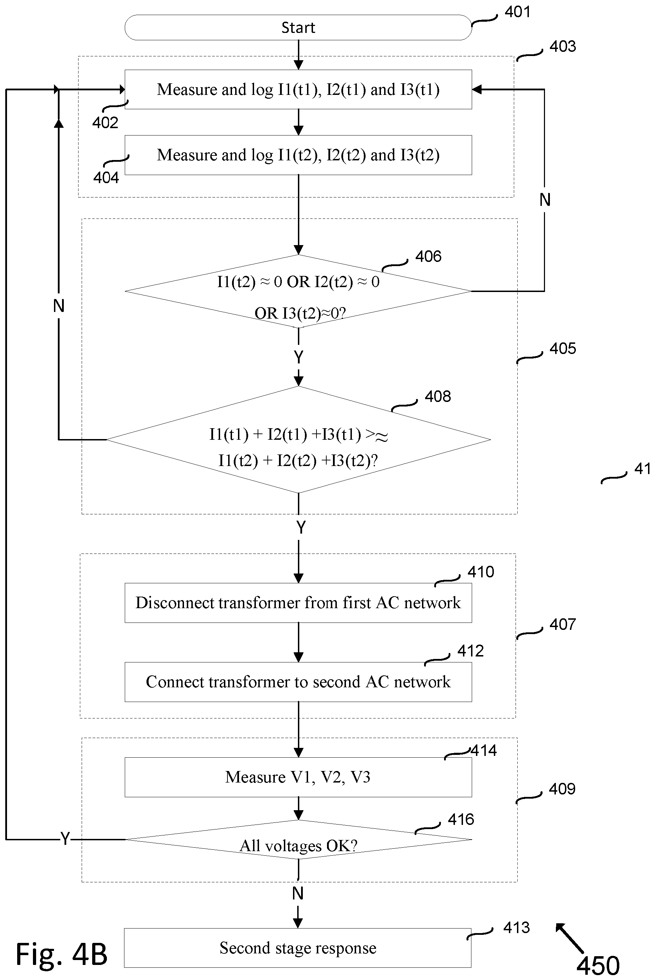

Reference is now made to Fig. 4B, which illustrates a method for detecting potential and confirmed islanding conditions in AC networks. Method 450 may be similar to method 400 of Fig. 4A, with certain steps of method 400 explained in greater detail.

At step 401, the start of method 450, an energy system such as systems 100A-100C may be operating according to the disclosure herein. For example, considering system 100C, a utility grid 130 may be connected to STS 108 via AC interface 109A, generator 140 might be connected to AC interface 109B, but at the start of method 450, the contactor of AC interface 109B may be in the OFF state, disconnecting generator 140 from STS 108. BINV 104 may be discharging BESS 103 at a first rate of discharge, and loads 106 may be drawing power from both AC network 110 and BESS 103 (via BINV 104). At step 403, SSI 115C may be providing voltage and current measurements to controller 107, which may monitor (e.g., identify and track changes) and log the measurements over time. Step 403 may comprise steps 402 and 404. At step 402, SSI 115C may provide, to controller 107, measurements of currents I1, I2 and I3 which may flow through AC interface 109A between STS 108 and grid 130. At a first time, t1, controller 107 may receive the current measurements and save them to memory. In some cases, rather than save each measurement individually, controller 107 may save the sum of the currents (e.g., as calculated in "sumI(t1) = I1(t1)+I2(t1)+I3(t1)") to memory.

At step 404, at a second time, t2, controller 107 may receive updated current measurements from SSI 115C: I1(t2), I2(t2), I3(t2). At step 406, which may form part of step 405 of method 400, controller 107 may compare the new current values of I1 (t2), I2(t2), and I3(t2) to the previously measured current values, and may determine whether one of I1, I2 and I3 is equal to substantially zero at time t2. If one of the currents is equal to substantially zero (e.g., several hundred milliamperes, compared to a previous value of substantially more than zero), the controller may proceed to step 408 and compare the sum of all three currents I1(t2)+I2(t2)+I3(t2) to the previous sum of I1(t1)+I2(t1)+I3(t1). If the sums are not substantially the same, the current change may be due to an unbalanced a change in load, and the controller may determine that no network fault such as a partial islanding condition is present. In this case, the controller may return to step 402. In some cases (not explicitly illustrated), controller 107 may take responsive action such as transferring one of loads 106 from one phase to another. In some cases, if the total current I1(t2)+I2(t2)+I3(t2) is greater than the previous total current I1(t1)+I2(t1)+I3(t1), controller 107 may determine that the total load has increased, and additionally that one of the phases may have failed, and may accordingly determine that a potential islanding condition exists.

At step 408, if the controller determines that the two current sums are substantially the same, this may be an indicator of a disconnected phase, which may be a partial islanding condition. In that case, the controller may proceed to step 410 and (which may be part of step 407 of method 400) and disconnect transformer 105 from grid 130, using STS 108 and a contactor from AC interface 109A. At step 412, controller 107 may connect transformer 105 to generator 140, using STS 108 and a contactor from AC interface 109B.

In some cases, such as during the transition between connection to grid 130 and generator 140, the controller 107 may instruct BINV 104 or PV inverter 102 to increase power generation in order to provide sufficient power to loads 106.

At steps 414 and 416, which may correspond to step 409 of method 400, controller 107 may obtain voltage measurements from an SSI of AC interface 109A, in order to confirm that one or more of the phases of grid 130 has failed. At step 416, if controller 107 determines that one of the phases is not providing a proper voltage, the controller may proceed to step 413 and initiate a second stage response. For example, controller 107 may send an instruction to generator 140 to provide AC power at a reduced rate, as grid 130 may be faulty for an extended period of time.

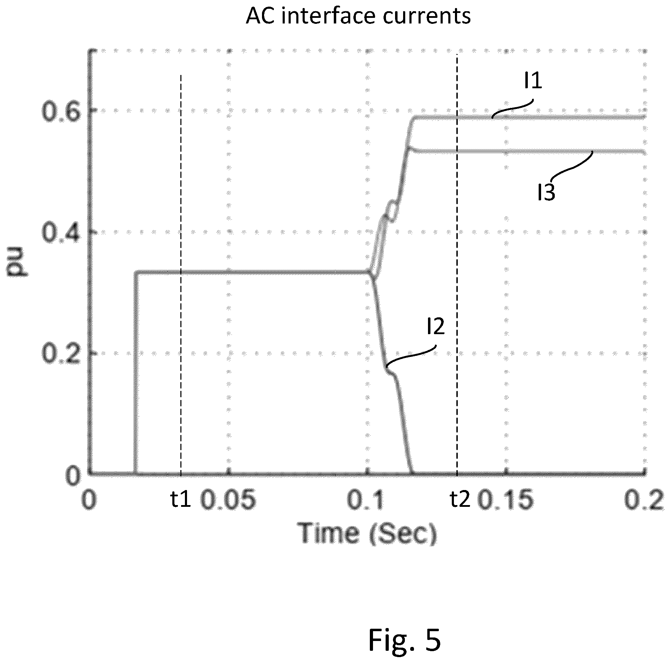

Reference is now made to Fig. 5, which shows current waveforms which may be measured during a partial islanding event, as disclosed herein. Currents I1, I2 and I3 may be monitored by an SSI (e.g., SSI 115C of Fig. 2) during operation of a backup interface. At time t1, all three currents may be substantially equal to 0.33pu, indicating a balanced load. At about t=0. 1sec, current I2 is shown dropping rapidly to substantially zero, while I1 rises to about 0.6pu and I3 rises to about 0.5pu, for a total of 1.1pu. This may indicate that a total power demand of loads 106 has risen about %10, and additionally, that phase I2 may have failed, and that a first stage response according to features disclosed herein may be desired. A controller (e.g. controller 107) executing method 400 of Fig. 4 and receiving, e.g. at step 403 measurements corresponding to currents I1, I2 and I3 of Fig. 5 may, based on the measurements, determine at step 405 that a system fault (e.g. as a phase loss condition) is suspected, and trigger a first stage response at step 407.

In some cases, controller 107 may, e.g. at step 405, distinguish a phase loss condition from other system events and/or faults, by applying mathematical calculations and/or transformations to current measurements, in addition to or instead of the method of comparing current measurements as described above. For example, controller 107 may transform measured phase currents I1, I2 and I3 to Clarke-transformed currents $I_\alpha$, $I_\beta$, $I_0$ via Clarke transformation equations:

$$ I\alpha = \frac{2}{3}I1 - \frac{1}{3}I2 - \frac{1}{3}I3; \ I\beta = \frac{\sqrt{3}}{3}(I2 - I3); I_0 = \frac{1}{3}(I1 + I2 + I3) $$

such that during normal operating condition (e.g. I1, I2 and I3 are balanced, having the same amplitude $I_n$ and phase-shifted by 120 degrees), the following equations hold: $I\alpha = In \sin(wt)$; $I\beta = In \cos(wti)$; $I0 = 0$ .

In case of loss of Phase 1 (I1=0), controller 107 may detect a reduction in a current peak of $I_\alpha$ from In to In/3, and $I_\beta$ may retain a peak amplitude of In but may become inverted (e.g. via a phase shift of 180 degrees). I0 may become non-zero. In case of loss of Phase 2 (I2=0) or Phase3 3 (I3=0), $I\alpha$ and $I\beta$ may become significantly distorted compared to previous values, and I0 may become substantially nonzero.

Calculation (e.g. by controller 107) of Clarke-transformation of currents may detect system events which affect AC currents but are not phase loss events, should not be interpreted as phase-loss events and should not trigger a phase-loss response. For example, unlike phase loss, which may result in a strong, sustained deviation in I0, an imbalanced load condition generally may present a reduced deviation in $I\alpha$, $I_\beta$, $I_0$, depending of a magnitude of imbalance. The deviation may be proportional to the load reduction in the affected phase. In commercial and industrial systems, a large imbalance may be generally rare, so based on the site load characteristics, a refined threshold may be set to distinguish phase imbalance from phase loss and reduce a number of false-positive detection of suspected phase loss events. As another example, a connection of a highly nonlinear load may inject third, fifth, seventh or higher-order harmonics into I1, I2 and I3 measurements. Harmonics, especially the 3rd, 5th, and 7th-order harmonics, may introduce high-frequency distortions in current waveforms. While traditional phase loss detection methods may often misinterpret these distortions as faults, use of the Clarke transformation may provide a structured way to distinguish between harmonics and phase loss, and may reduce a number of false-positives.

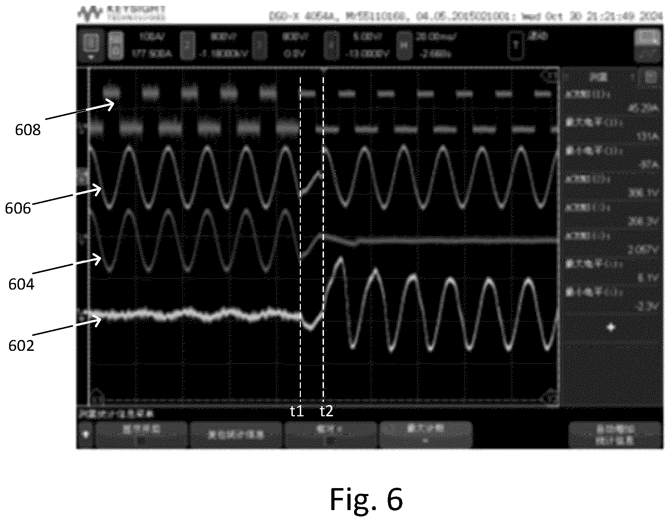

Reference is now made to Fig. 6, which illustrates example experimental waveforms measured at a backup interface (e.g. backup interface 120C) according to features of the disclosure herein. Signal 602 may represent a phase current output by a battery inverter (e.g. battery inverter 104). Signal 604 may represent a grid phase current (e.g. I1). Signal 606 may represent an output phase voltage (e.g., measured by a voltage sensor measuring a phase voltage provided to loads 106, such as a voltage sensors of SSI 115A, not explicitly illustrated). Signal 608 may represent a synchronization signal provided to battery inverter 104 to ensure it is synchronized with grid voltages (e.g., as measured by a voltage sensor 112a, 112b or 112c). Prior to time t1, as shown in Fig. 6, signal 602 is approximately zero, as the battery inverter is not providing current. Grid phase current signal 604 and load voltage signal 606 are sinusoidal and approximately in-phase, indicating normal operation. At time t1, a controller (e.g. controller 107) may determine that a phase loss is suspected, signal the battery inverter to commence providing power from a battery and disconnect the backup interface 120C from the grid (e.g. via contactor 117 and/or STS 108). After a brief (<10ms) transient, load current signal 604 is approximately zero battery inverter current signal 602 provides the current previously indicated by load current signal 604. After a brief transient of instability due to the disconnecting and current transfer, voltage signal 606 may resume its sinusoidal form at time t2.

Some or all of the electronic devices (e.g. PV inverter 102, BINV 104, and/or other devices) according to the disclosure herein may feature one or more Insulating Sheet(s), Spacer, and Spacer Holder(s) as described in U.S. provisional patent application no. 63/570,990, which is incorporated herein by reference in its entirety. Further, some or all of the electronic devices disclosed herein may feature a heat spreader such as disclosed in U.S. provisional patent application no. 63/725,124, which is incorporated herein by reference in its entirety. Some or all of the electronic devices according to the disclosure herein may be used as part of an electrical-vehicle charging network, as described in U.S. provisional patent application no. 63/573,094, which is incorporated herein by reference in its entirety.

The aforementioned description will so fully reveal the general nature of the implementation of the disclosure that others can, by applying knowledge within the skill of the art, readily modify and/or adapt for various applications such specific implementations without undue experimentation and without departing from the general concept of the present disclosure. Therefore, such adaptations and modifications are intended to be within the meaning and range of equivalents of the disclosed implementations, based on the teaching and guidance presented herein. It is to be understood that the phraseology or terminology herein is for the purpose of description and not of limitation, such that the terminology or phraseology of the present specification is to be interpreted by the skilled artisan in light of the teachings and guidance.

Each implementation described may include a particular feature, structure, or characteristic, but every implementation may not necessarily include the particular feature, structure, or characteristic. Moreover, such phrases are not necessarily referring to the same implementation. Further, when a particular feature, structure, or characteristic is described in connection with an implementation, it is submitted that it is within the knowledge of one skilled in the art to affect such feature, structure, or characteristic in connection with other implementations whether or not explicitly described.

The exemplary implementations described herein are provided for illustrative purposes, and are not limiting. Other implementations are possible, and modifications may be made to the exemplary implementations. Therefore, the specification is not meant to limit the disclosure. Rather, the scope of the disclosure is defined only in accordance with the following claims and their equivalents.

The present application also discloses the subject matter of the following clauses.

Clause 1: A method comprising:

monitoring a first current, flowing through a first phase of a three-phase transformer, to determine a first current change;
monitoring a second current, flowing through a second phase of the three-phase transformer, to determine a second current change;
monitoring a third current, flowing through a third phase of the three-phase transformer, to determine a third current change; and
responsive to determining that:

the first current change is a negative value greater than a first threshold,
the second current change is a first positive value,
the third current change is a second positive value, and
a sum of the first current change, the second current change, and the third current change is zero,

activating a disconnection response.

Clause 2: A system comprising:

a battery energy storage system (BESS);
a bidirectional direct current to alternating current converter (DC/AC converter) comprising direct current (DC) terminals coupled to the BESS and alternating current (AC) terminals;
a multiphase transformer comprising a primary winding side coupled to the DC/AC converter, and a secondary winding side; and
an AC interface, coupled to the secondary winding side of the multiphase transformer and coupled to an AC network, wherein the AC interface comprises:

a controller;
a plurality of current sensors, each configured to measure current on a corresponding phase of the secondary winding side and to provide current measurements to the controller,
wherein the controller is configured to:

evaluate, based on the current measurements, a potential phase loss condition; and
responsive to identifying a potential phase loss condition, initiate a first-order response.

Clause 3: The system of clause 2, wherein the primary winding side comprise delta windings.

Clause 4: The system of clauses 2 or 3, wherein the secondary winding side comprise Y-windings.

Clause 5: The system of any of clauses 2-4, wherein the AC interface further comprises a plurality of voltage sensors, each configured to measure voltage across a corresponding phase of secondary-windings of the secondary winding side and to provide voltage measurements to the controller, and
wherein the controller is configured to determine, based on the voltage measurements and based on identifying the potential islanding condition, whether a phase loss condition has occurred.

Clause 6: The system of any of clauses 2-5, wherein the controller is configured to, based on determining that no phase loss condition has occurred, operate the switch to connect the transformer to the AC network.

**Claims**

1. A method comprising:

   determining first measurements of a first current flowing through a first phase of an alternating current (AC) network at a first time and at a second time;
   determining second measurements of a second current flowing through a second phase of the AC network at the first time and at the second time;
   determining third measurements of a third current flowing through a third phase of the AC network at the first time and at the second time;
   determining a comparison result by comparing the first, second and third measurements at the first time to the first, second and third measurements at the second time;
   based on the comparison result, determining a phase loss condition; and
   based on the phase loss condition indicating risk of phase loss, activating a first stage fault response.

2. The method of claim 1, wherein determining a comparison result comprises comparing a first sum of the first, second, and third currents at the first time to a second sum of the first, second, and third currents at the second time.

3. The method of claims 1 or 2, wherein determining a comparison result comprises comparing Clarke-transformation values of the first, second and third currents at the first time to Clarke-transformation values of the first, second and third currents at the second time.

4. The method of any of claims 1-3, wherein the activating the first stage fault response comprises disconnecting a transformer from the AC network.

5. The method of claim 4, further comprising:

   measuring a first phase voltage, a second phase voltage, and a third phase voltage across the first, second, and third phases of the AC network; and
   responsive to determining that the first phase voltage is zero, activating a second stage fault response.

6. The method of claim 5, wherein the activating the second stage fault response comprises connecting a generator to a load coupled to the transformer, and operating the generator according to a backup mode.

7. The method of claims 5 or 6, wherein the activating the second stage fault response comprises operating an energy storage system connected to the transformer according to a backup mode.

8. The method of any of claims 5-7, wherein the operating the energy storage system in the backup mode comprises selectively charging and discharging a battery bank of the energy storage system according to a backup mode algorithm.

9. The method of claim 7, wherein the operating the energy storage system in the backup mode comprises providing electrical power to a load selected for backup.

10. The method of any of claims 5-9, wherein the operating the energy storage system in the backup mode comprises connecting a neutral point of the transformer to a ground.

11. The method of any of claims 1-10, further comprising:

    measuring a first phase voltage, a second phase voltage, and a third phase voltage across the first, second, and third phases of the AC network; and
    responsive to determining that the first phase voltage is not zero, reconnecting a transformer to the AC network.

12. The method of any of claims 1-11, further comprising:

responsive to determining that the first current is zero at the second time, determining a comparison by comparing:

a first sum of the first, second, and third currents at the first time, and
a second sum of the first, second, and third currents at the second time; and

responsive to the comparison not satisfying a threshold, maintaining a current operational state.

13. A system comprising:

a battery energy storage system (BESS);
a bidirectional direct current to alternating current converter (DC/AC converter) comprising direct current (DC) terminals coupled to the BESS and alternating current (AC) terminals;
a multiphase transformer comprising a primary winding side coupled to the DC/AC converter, and a secondary winding side; and
an AC interface, coupled to the secondary winding side of the multiphase transformer and coupled to an AC network, wherein the AC interface comprises:

a controller;
a plurality of current sensors, each configured to measure current on a corresponding phase of the secondary winding side and to provide current measurements to the controller,
wherein the controller is configured to:

evaluate, based on the current measurements, a potential phase loss condition; and
responsive to identifying a potential phase loss condition, initiate a first-order response.

14. The system of claim 13, wherein the first-order response comprises operating a switch to disconnect the transformer from the AC network.

15. The system of claims 13 or 14, wherein the first-order response comprises operating the DC/AC converter to provide backup power to one or more loads.

Fig. 1

Fig. 2

Fig. 3

Fig. 4A

Start — 401

Measure and log I1(t1), I2(t1) and I3(t1) — 402 — 403

Measure and log I1(t2), I2(t2) and I3(t2) — 404

I1(t2) ≈ 0 OR I2(t2) ≈ 0 OR I3(t2)≈0? — 406

N

Y

I1(t1) + I2(t1) +I3(t1) >≈ I1(t2) + I2(t2) +I3(t2)? — 408 — 405

N

Y

Disconnect transformer from first AC network — 410

Connect transformer to second AC network — 412 — 407

Measure V1, V2, V3 — 414

All voltages OK? — 416 — 409

Y

N

Second stage response — 413

Fig. 4B

450

41

AC interface currents

Fig. 5

Fig. 6

**EP 4 632 986 A1**

# EUROPEAN SEARCH REPORT

**Application Number**

EP 25 16 3745

Europäisches Patentamt
European Patent Office
Office européen des brevets

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 115 902 433 A (GREE ELECTRIC APPLIANCES INC ZHUHAI) 4 April 2023 (2023-04-04) | 1-4,12 | INV. H02J3/00 |
| A | * paragraphs [0066] - [0101]; claim 1 * | 5-11, 13-15 | H02J3/26 H02J3/32 H02J3/38 |
| X | CN 115 060 987 B (JI HUA LABORATORY) 8 November 2022 (2022-11-08) * paragraphs [0010] - [0020]; claims 1-3 * | 1-4,12 | G01R29/18 |
| X | CN 114 778 961 A (GREE ELECTRIC APPLIANCES INC ZHUHAI) 22 July 2022 (2022-07-22) * paragraphs [0135] - [0147] * | 1-4,12 | |
| X | JP 2016 206096 A (KINKEI SYSTEM CORP) 8 December 2016 (2016-12-08) * paragraphs [0038] - [0058]; claim 1 * | 1 | |
| X | US 2023/121559 A1 (YU DACHUAN [US] ET AL) 20 April 2023 (2023-04-20) * paragraphs [0041] - [0046]; figure 1 * | 13,14 | |

**TECHNICAL FIELDS SEARCHED (IPC)**

H02J
G01R

The present search report has been drawn up for all claims

| Place of search | Date of completion of the search | Examiner |
|---|---|---|
| Munich | 20 August 2025 | Grosse, Philippe |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 16 3745

This annex lists the patent family members relating to the patent documents cited in the above-mentioned European search report.
The members are as contained in the European Patent Office EDP file on
The European Patent Office is in no way liable for these particulars which are merely given for the purpose of information.

20-08-2025

| Patent document cited in search report | | Publication date | Patent family member(s) | Publication date |
|---|---|---|---|---|
| CN 115902433 | A | 04-04-2023 | NONE | |
| CN 115060987 | B | 08-11-2022 | NONE | |
| CN 114778961 | A | 22-07-2022 | NONE | |
| JP 2016206096 | A | 08-12-2016 | JP 5926419 B1 | 25-05-2016 |
| | | | JP 2016206096 A | 08-12-2016 |
| US 2023121559 | A1 | 20-04-2023 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63565675
- US 63570990
- US 63725124
- US 63573094